# EUROPEAN PATENT SPECIFICATION

(11) **EP 0 547 399 B1**
(45) Date of publication and mention of the grant of the patent: **31.01.1996**
(21) Application number: 92119837.0
(22) Date of filing: 20.11.1992
(51) Int. Cl.: H01L 21/00

(54) **Frangible semiconductor wafer dicing method which employs scribing and breaking**
Verfahren zum Schneiden von zerbrechlichen Halbleiterplättchen mit Anwendung von Anritzen und Brechen
Procédé pour couper une plaquette de semi-conducteur cassable en employant la striation et le brisement

(30) Priority: 06.12.1991 US 804135
(43) Date of publication of application: 23.06.1993
(73) Proprietor: Loomis, James W., St. Helena, California 94574 (US)
(72) Inventor: Loomis, James W., St. Helena, California 94574 (US)
(74) Representative: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) References cited:
- EP-A- 0 346 997
- EP-A- 0 346 997
- US-A- 4 352 446
- US-A- 4 352 446
- US-A- 4 653 680
- US-A- 4 653 680

## Description

### FIELD OF THE INVENTION

This invention relates to improvements in the handling of substrates which are easily broken and, more particularly, to apparatus and a method for scribing and breaking substrates such as semiconductor wafers, thin glass and the like.

### BACKGROUND OF THE INVENTION

As is well known, semiconductor wafers are scribed along specific lines and thereafter separated along such lines to divide the wafer into semiconductor chips. Such division lines can be scribed with a diamond-pointed scribing tool or cut by a laser or saw. However, when the lines are scribed or partially cut, the wafer is not immediately separated into its individual pieces but must be broken after scribing has occurred.

From US-PS 4,653,680 an apparatus and a method for breaking a scribed semiconductor wafer and the like is known. The known apparatus includes a wafer support which is movable with respect to a breaker arm having a knife-edge. The breaker arm is actuated pneumatically or by other similar means to impart a shock or impulse to the wafer along each of the wafer scribe lines so as to fracture the wafer. A control mechanism is provided for automatically alternately stepping the wafer position with respect to the breaker arm and actuating the breaker arm. Once the entire wafer has been broken along one axis, the wafer is rotated ninety degrees and the sequence is repeated along the other axis.

Many attempts have been made to provide apparatus for breaking a semiconductor wafer into individual pieces with each piece representing a particular semiconductor chip. For the most part, these attempts have been unsatisfactory for one or more reasons. Specifically, the yield of a wafer using conventional techniques has been relatively low, and the loss of a large number of semiconductor chips from a given wafer represents a large loss in profits which could be realized if the yield were greater.

Breaking a scribe line is implemented by putting it in tensile strain. The point or bottom of the vertical crack under the scribe line will start experiencing molecular bond failures; slowly at first and increasing in an avalanche fashion. When the bond failure becomes quite rapid, the strain energy required to feed the failing is minuscule in relation to the tensile strength of the material. When the rapid bond failure initiates, it commonly starts at the edge of the wafer. The strain induced around the unbroken scribe line is released as the scribe line starts to fail and supplies the necessary energy to feed the break along the scribe line.

Until this invention, all known breaking methods and apparatus applied the tensile breaking strain in a mass fashion; e.g. causing the wafer to conform to a convex cylindrical section parallel to the scribe lines, or causing a single scribe line to bend about an edge in a guillotine fashion. All of these techniques attempt to break a scribe line instantly. Since scribe lines always break in a serial fashion from point A to point B, not instantaneously, the strain energy built up in the material affects the completion of the break. Usually, this residual strain energy is too much and ill-applied to achieve a perfect break. The excess applied strain contributes to chipping, edge degradation and skew (off scribe line) breaks.

Additionally, the traditional breaking methods always touch the entire surface of the wafer. With the introduction of "air-bridge" circuits (very thin micro-conductors, suspended over other conductors with the air space between acting as an insulator), breaking wafers has become more difficult because the air bridges are very fragile and must not be touched or contaminated during the breaking operation. Because of the drawbacks associated with conventional breaking techniques, a need has continued to exist for some time for an improved breaking apparatus and method to permit high yields yet provide for simplicity in operation without interference with the scribing step. The present invention satisfies this need because not only does it apply a limited (and adjustable) strain just necessary to drive the bond failures along the scribe line, but it also integrates breaking with scribing and thus can locate breaking forces outside the active circuit areas, which is normally the wafer separation grid area.

### SUMMARY OF THE INVENTION

The primary object of the present invention is to provide a substrate breaking apparatus and method, whereby an entire substrate can be broken along a plurality of scribe lines to hereby simplify the division of the substrate into small pieces.

Another object of the present invention is to provide an apparatus and a method, wherein the breaking of a substrate can be accomblished immediately after a scribe line has been formed the substrate, whereby the present invention is suitable for scribing and breaking a semiconductor wafer into individual semiconductor chips.

These objects are achieved by the features of independent claims 1 and 32.

Accordingly, the present invention is directed to an apparatus and method for handling frangible substrates, such as semiconductor wafers, thin glass, etc., wherein a substrate can be scribed and immediately thereafter broken into rows of strips then subsequently scribed and broken into individual chips (or "die", the entire operation generally referred to as "scribing and dicing"). The scribing and breaking steps can be achieved while realizing high yield and provide for almost immediate breaking after scribing without interference with the scribing of the substrate.

To this end, the present invention provides the breaking of a substrate along the scribed lines on a substrate in a translating three-point beam bending system wherein beam bending forces are applied at two locations in a translating fashion on one side of the wafer and at a third point on the opposite side of the wafer between the first two points to permit the forces to be exerted on the substrate in breaking relationship thereto along the scribed lines.

The apparatus of the present invention further includes, in a preferred embodiment of the breaking means, a rotatable break wheel that is selectively engageable via its two profiles with the substrate on opposite sides of a line scribed by a scribing tool, the break wheel and tool being movable relative to the substrate preferably along straight lines. Thus, the wheel and tool can move relative to and along a surface of the substrate or, alternatively, the substrate can move while the wheel and tool remain stationary.

### Version One:

In the breaking of the substrate, the break wheel profiles, when they engage one surface of the substrate, provide two of the three points of a three-point beam bending system relied upon in the present invention for breaking the substrate along a scribed line. The third point of the three-point beam bending mode is provided by a fixed abutment or support, preferably a mandrel, having an inclinable surface. The left wheel profile is positioned so it is incident on the portion of the substrate supported by the inclinable mandrel. The right wheel profile is positioned so it is incident on the cantilevered portion of the substrate. Since the downward travel of the break wheel is limited by the left profile engaging the supported portion of the wafer, the maximum strain induced around the unbroken portion of the scribe line is adjusted by changing the angle of the inclinable mandrel.

### Version Two:

A second version of this breaking method uses a break wheel with three profiles. The center profile engages the substrate directly on the scribe line, the left and right profiles are positioned as in version one. The angle of the inclinable mandrel is set to the angle of the contact line of the left and center profiles. This angle is determined by the difference in diameter of the center and outer profiles of the break wheel, the center profile diameter always being less than either outer profile diameter. In this version of the invention, the downward travel of the break wheel is limited by the left and center profiles engaging the supported substrate. Therefore the maximum strain induced around the unbroken portion of the scribe line is limited by the contact line angles of the center and outer break wheel profiles built into the break wheel.

### Version Three:

A third version of this breaking method uses a combination of the techniques used in versions one and two above. Again, a three profile break wheel is used as in version two, except that it is shifted slightly to the right, so that the center profile is just to the right of the inclinable mandrel, and it engages the substrate on the cantilevered portion of the substrate. As in version one, the left profile engages the unbroken substrate over the inclinable mandrel, thus limiting the break wheel's downward travel, so the angle of the mandrel sets the maximum strain induced around the unbroken scribe line.

As the substrate breaks along the scribe line, the center wheel profile pushes the newly broken portion of the substrate down, causing a shearing action to take place between the unbroken and newly broken portions of the substrate. This helps shear any backside metallization of the substrate. Other breaking techniques fail to address the issue of ductile, backside metallization, which generally leave the wafer in a condition where the chips are broken from each other, yet still attached via the backside metal (generally referred to as "gold hinge").

### Version Four:

A fourth version of this breaking method is used where the separation grid of the substrate is not in the same plane of the rest of the substrate, as in wafers where large contact "bumps" are part of the active circuit area. Here the wheel setup is the same as in version two, with the center wheel profile engaging the substrate directly over the scribe line. The inclinable mandrel is replaced with a fixed narrow blade that fits between the bumps on the substrate.

Since the center wheel profile is limited in its downward travel by the substrate supported on the blade, the breaking strain is controlled by the contact angle between the center and outer profiles of the break wheel.

The invention can form part of a wafer scribing and dicing machine which is conventional in construction. The scribing tool of such a machine reciprocates relative to the substrate to be scribed. The substrate is scribed as the scribe tool engages the substrate and moves in one direction. Then the tool is disengaged from the substrate, the break wheel engages the substrate and the wheel is moved to the opposite side of the wafer, separating the wafer along the scribed line. Then the wheel is disengaged from the substrate and the wafer is indexed laterally and incrementally while both scribe tool and break wheel are disengaged from the substrate.

The break wheel is mounted on an arm coupled to the machine and preferably movable with the scribe tool back and forth past a substrate to be scribed and broken. The drive means for moving the tool back and forth can also be the drive means for the arm carrying the wheel. The arm carrying the wheel is independently raised and lowered with respect to the scribe tool and is lifted from the substrate after a single pass of the wheel relative to the substrate in breaking relationship thereto. The wheel can move and operate with the mandrel as breaking means as a function of the motion of the scribe tool itself, or the break wheel can operate with the mandrel in a reciprocal fashion from the motion of the scribe tool.

The primary object of the present invention is to provide a substrate breaking apparatus and method suitable for use with a substrate scribing tool wherein the breaking means comprises a three-point beam bending system which serves to apply forces to a substrate scribed by the tool to break the substrate along the scribe lines thereof while the substrate is held, yet the substrate can be moved incrementally and transversely to the direction of movement of the scribe tool, whereby an entire substrate can be broken along a plurality of scribe lines to thereby simplify the division of the substrate into small pieces.

Another object of the present invention is to provide an apparatus and methods of the type described wherein the breaking of a substrate can be accomplished immediately after a scribe line has been formed in the substrate, whereby the present invention is suitable for scribing and breaking a semiconductor wafer into individual semiconductor chips.

Other advantages and objects of the present invention will become apparent as the following specification progresses, reference being had to the accompanying drawings for an illustration of the present invention.

### BRIEF DESCRIPTION OF THE DRAWINGS

Fig. 1 is a front elevational view of two-profile break wheel engaging substrate;
Fig. 2 is a front elevational view of three-profile break wheel engaging substrate;
Fig. 3A is a front elevational view of three-profile break wheel with center profile shifted to the right;
Fig. 3B is a close-up of the view of Fig. 3A;
Fig. 4A is a front elevational view of three-profile break wheel with the inclinable mandrel replaced with a narrow blade;
Fig. 4B is a close-up of the view of Fig. 4A;
Fig. 5 is a top elevational view of the scribing machine and breaking means thereon, showing the relationship of x-axis (incremental motion of substrate) and y-axis (linear translation system for scribe tool and break wheel); and
Fig. 6 is a side view of the scribing machine, showing relationship of the y-axis and the z-axis (independent raising and lowering of scribe tool) and the break wheel to engage substrate.

### DETAILED DESCRIPTION OF THE DRAWINGS

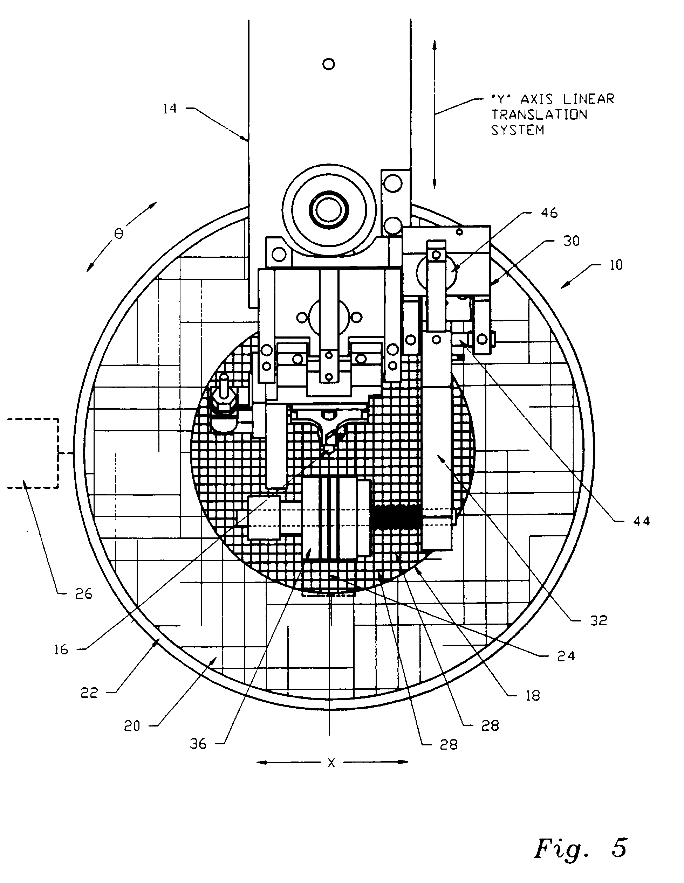

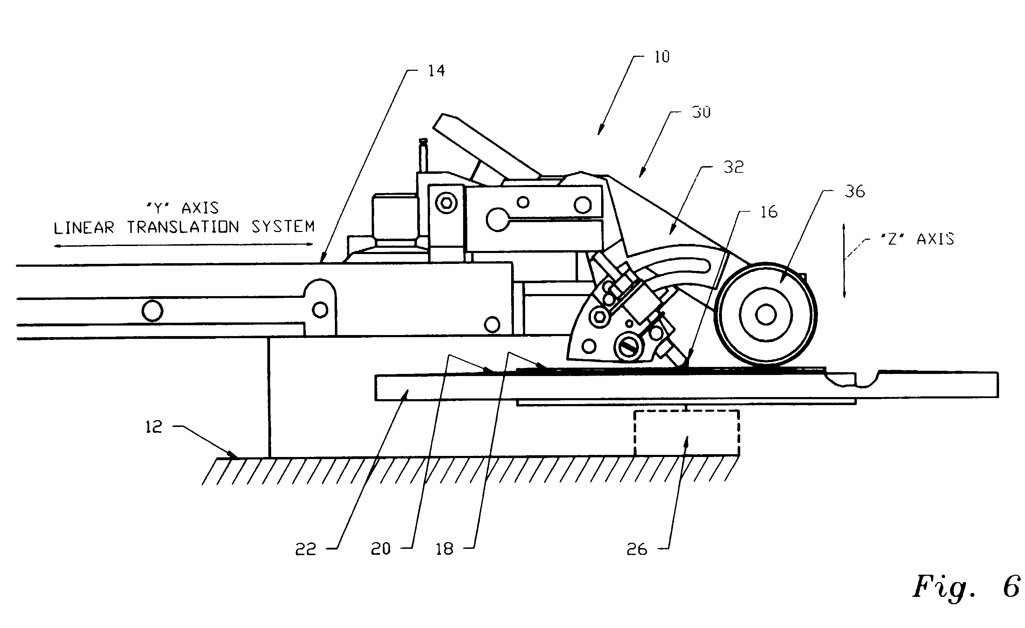

The scribing and dicing apparatus of the present invention is broadly denoted by the numeral 10 and is shown in Figs. 5 and 6. Apparatus 10 includes a base 12 for supporting a linear translation system 14 to which is coupled a scribe tool 16 for scribing a semiconductor or other wafer 18 mounted on a stretchable adhesive sheet 20 carried by a circular hoop or any other suitable conveyance mechanism 22 coupled in some suitable manner to base 12. The wafer 18 is adhesively bonded to the upper surface of the adhesive sheet 20, and the wafer is scribed by tool 16 as the tool moves under the influence of linear translation system 14 in one direction, such as to the left when viewing Fig. 6. As it moves to the left, the scribe tool scribes a line 24a (Fig. 5) as the tool 16 moves over the wafer 18 in one direction. After a line has been scribed by the tool 16, the linear translation system 14 is caused to lift tool 16 above the wafer, then the tool is returned to its initial starting position or to the right when viewing Fig. 6 where the tool is in a position to scribe the next line. During a pause in the forward most travel to the right (when viewing Fig. 6) of the tool, the hoop 22 and sheet 20 are indexed by an indexing means 26 which will cause the sheet and hoop to incrementally move to the right when viewing Fig. 5 so as to position the tool 16 in a proper location for scribing the next scribe line.

The tool continues to scribe wafer 18 until all of the lines parallel to line 24 shown in Fig. 5 have been scribed. After this has occurred, the hoop and sheet 20 and 22 are then rotated through an angle of 90° so that the wafer 18 will be in a position to be scribed by the tool along lines 28 which are perpendicular to line 24.

The foregoing explanation relates to a scribing machine which is conventional in construction and operation. In the past, such a conventional machine was used merely to scribe a wafer, following which the scribed wafers would be removed from the machine and handled so as to separate the die or chips 25 formed by the formation of the perpendicular scribe lines 24 and 28 (Fig. 5). A typical scribing machine of conventional construction is one made and sold by Loomis Industries of St. Helena, California.

A breaking unit 30 is associated with the scribing part of apparatus 10 and unit 30 is provided to cause breaking of a column of chips or wafer 18 after a scribe line has been formed in the wafer. The breaking means cooperates with the stretchable adhesive sheet 20 which retains the chips on the sheet until the chips are removed one by one such as by a vacuum pick up device, where the chips are transferred to a point of use, such as another substrate for mounting a chip in a position to be wire bonded or the like.

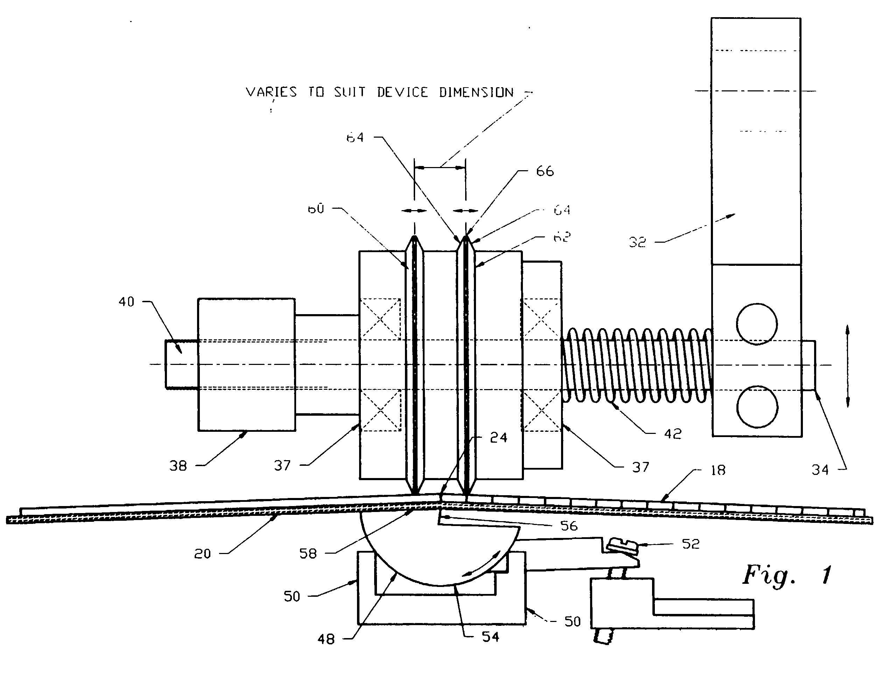

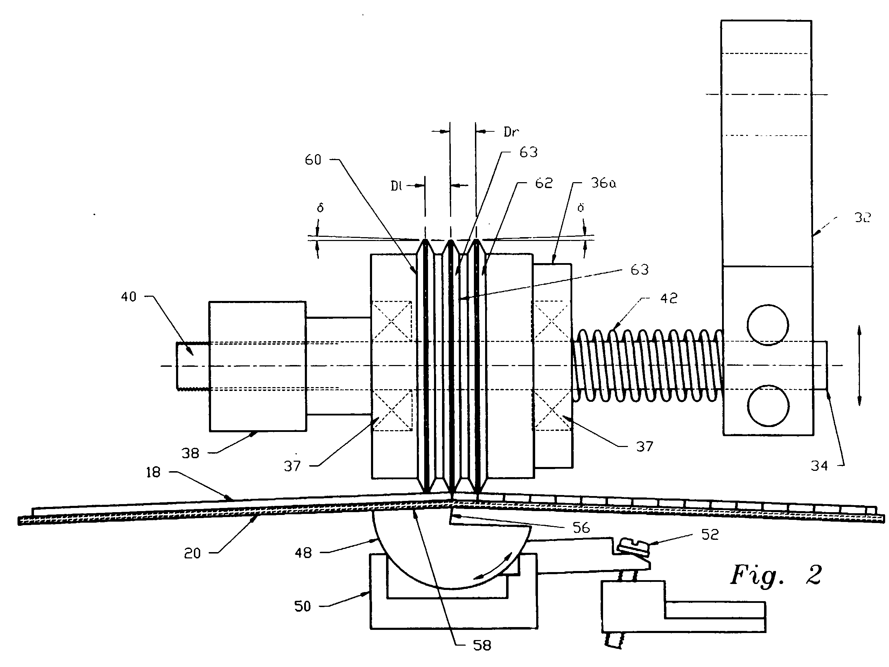

Breaking unit 30 includes a break wheel arm 32 having a shaft 34 extending laterally therefrom. A break wheel 36 is mounted on the shaft and has bearings 37 mounting the wheel for rotation on shaft 34. The break wheel is held by a nut 38 threaded on the outer end 40 of the shaft 34, the nut bearing against the wheel for compressing a spring 42 which biases the wheel away from the break wheel arm 32. Several embodiments of wheel 36 are hereinafter described, the first embodiment being shown in Fig. 1 and other embodiments being shown in Figs. 2, 3A and 4A.

The break wheel arm 32 is pivotally mounted on an axle 44 (Fig. 5) for rotation about a generally horizontal axis, the axle being mounted on the linear translation system 14 in some suitable manner so that arm 32 can move up and down around the axle 44.

A fluid piston and cylinder actuator 46 (Fig. 5) is used to pivot the arm 32 in a counterclockwise sense when viewing Fig. 6 so that the break wheel 36 (Fig. 1) can clear the wafer when the break wheel is to be returned to a starting position with respect to the scribe tool 16. As the arm 32 pivots upwardly with reference to Fig. 6, it carries break wheel 36 upwardly as well since the break wheel is mounted on the shaft 34.

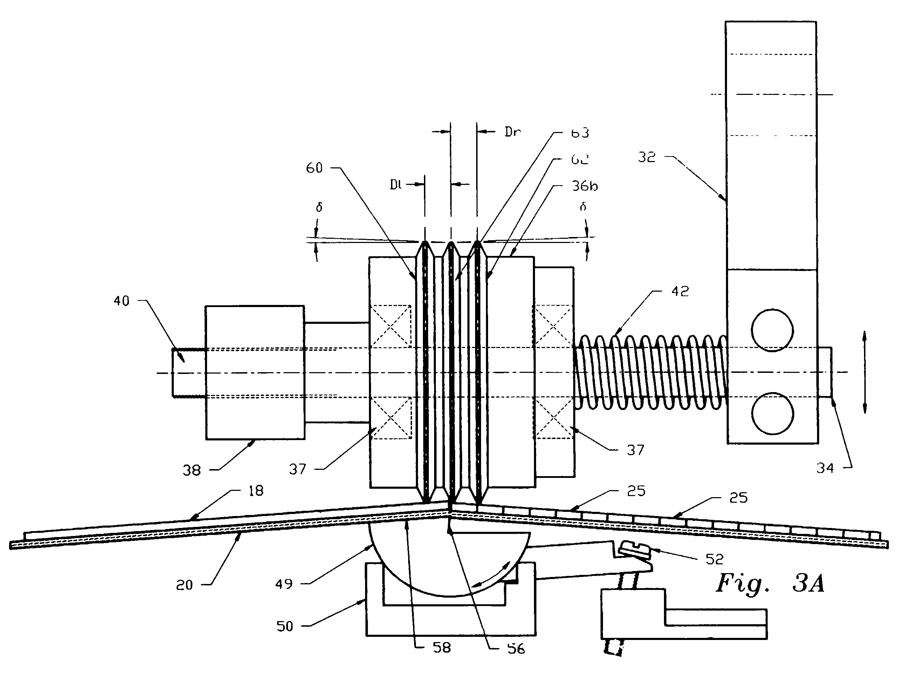

Also associated with breaking means 30 is an elongated mandrel 48 which is rotatably carried by a bracket 50 coupled with base 12 in any suitable manner. An adjustment screw 52 permits the mandrel to be rotated about its central axis, said axis being defined by the edge 56 (Fig. 3A) and being partially surrounded by the semicylindrical outer periphery 54 of the mandrel. The mandrel 48 has, adjacent to break edge 56, a break plane surface 58 which extends from the edge 56 to the outer periphery 54 as shown in Fig. 1.

The mandrel break plane surface 58 normally engages the lower surface of sheet 20 and the wafer 18 rests on sheet 20 and is supported by the lower break plane surface 58 as shown in Fig. 1.

Break wheel 36 has a pair of wheel profiles or profile members 60 and 62, each having a pair of sides 64 which converge to an outer, flat end face 66 which engages the wafer 18. The left hand member 60 engages the wafer in the unscribed portion thereof on one side of the scribe line 24; whereas, the other or right hand member 62 engages the wafer over the scribe line 24. Depending upon the angle of plane surface 58, a greater or lesser amount of strain or downward force is applied to the wafer to break the wafer as the wheel rotates about the central axis of shaft 34.

In the first embodiment of the wheel as shown in Fig. 1, the break wheel profile members 60 and 62, when they engage the upper surface of the substrate provide two of the three points of a three-point beam bending system for breaking the substrate along a scribed line. The third point of the three-point beam bending mode is provided by mandrel 48, specifically surface 58 thereof which is inclined. The profile member 60 is positioned so that it is incident on the portion of the substrate supported by the surface 58 of mandrel 48. Since the downward travel of the break wheel is limited by the left profile member 60 engaging the supported portion of the wafer, the maximum strain induced around the unbroken portion of the scribed line is adjusted by changing the angle of the inclined surface 58. This is achieved by adjusting screw 52 or some other means for pivoting the mandrel 48 about its central axis relative to bracket 50.

In the use of the embodiment of Fig. 1, wafer 18 is held on the upper surface of adhesive sheet 20 in the manner shown in Fig. 1. Sheet 20 is held taut by hoop frame 22 (Fig. 6) and the sheet is mounted on the upper plane surface 58 of mandrel 48 (Fig. 1).

With wafer 18 aligned transversely along the x-axis (Fig. 5) and rotationally about the θ axis (Fig. 5), the separation grid channel and the most recent scribe line 24 are parallel and superimposed over break edge 56 of mandrel 48. The break edge 56 is at the center of rotation of mandrel 48 to assure break edge 56 will be stationary during adjustment of inclinable surface 58 by way of adjusting of screw 52.

As shown in Fig. 1, the last scribed line 24 extends longitudinally in the direction of movement of the break wheel 36. The traversing step is accomplished by actuating linear translation system 14 (Fig. 6) which conveys the scribe tool 16 and break wheel system 30 such that the line is scribed in the wafer by the tool 16 as the wheel is elevated above and spaced above the wafer during movement to the left when viewing Fig. 6.

Typically, the wheel is lowered onto the wafer when the wheel moves from left to right and as the tool also moves from left to right in an elevated position above the wafer. Thus, during the scribe operation, the breaking wheel is out of contact with the wafer; whereas, during the return of the tool in an elevated position to its starting position, the break wheel is lowered and engages the wafer for breaking the wafer along the previously formed scribe line 24 as the break wheel 36 moves from left to right when viewing Fig. 6.

In the Fig. 1 embodiment, tensile strain is created transversely across the scribe line 24 by pushing wafer 18 on opposite sides of scribe line 24 with break wheel profile members 60 and 62. Members 60 and 62 roll across the wafer parallel to the last scribe line 24 as the profiles are conveyed by the linear translation system 14, causing tensile strain across the scribe line to travel along the length of the scribe line 24.

The maximum tensile strain induced across the scribe line 24 is adjusted by changing the angle of break plane surface 58 of mandrel 48. When surface 58 is rotated counterclockwise around edge 56, wheel profile members 60 and 62 bend the wafer more about the scribe line 24 and thus induce more tensile strain across the scribe line 24 prior to the breaking of the scribe line 24. Conversely, the tensile strain is reduced when surface 58 is rotated clockwise around break edge 56 by screw 52. In effect, the maximum tensile strain is adjusted across scribe line 24 so that failure occurs along line 24 directly between the break wheel profile members 60 and 62 or a short distance in front of break wheel motion.

Fig. 2 shows another embodiment of the breaking wheel of the present invention, the break wheel being denoted by the numeral 36a. Wheel 36a differs from wheel 36 (Fig. 1) in that wheel 36a has three annular profile members 60, 62 and 63 (Fig. 2) associated with it, member 63 being between members 60 and 62. Again, a wafer 18 is mounted on the adhesive portion of sheet 20, and the sheet is held taut by hoop 22 (Fig. 6) and is held over mandrel 48.

Break edge 56 of mandrel 48 is at the center of rotation of the mandrel 48 to assure break edge 56 is stationary during adjustment of inclinable plane surface 58. Adjustment can be achieved by a screw such as screw 52 (Fig. 1).

The scribe line 24 traverses entirely a separation grid channel which is located over break edge 56 of the mandrel 48. The movement of the wheel 36a and wheel arm 32 is accomplished by linear translation system 14 (Fig. 6) which conveys scribe tool 16 and break wheel system 30 including arm 32.

Tensile strain is created transversely across the scribe line 24 by pushing wafer 18 on opposite sides of scribe 24 with break wheel profiles 60 and 62. Break wheel profile members 60 and 62 roll across the wafer 18 parallel to scribe line 24 as they are conveyed by the linear translation system 14 causing tensile strain across scribe line 24 to travel along the length of the scribe line 24.

Tensile strain is limited by the center profile member 63 of the wheel 36a and also by the left profile member 60 engaging the upper surface of the wafer 18 over break plane surface 58 of mandrel 48, thus limiting downward travel of break wheel 36a. The break plane surface 58 is equal to the angle δ which is the contact angle between the center profile member 63 and left profile member 60. The maximum tensile strain developed is a function of the angle δ which, in turn, is a function of the diameter of the center profile member 63 in relation to the diameters of outer profile members 60 and 62. The break wheel 36a is made so that the diameter of the left profile member 60 is equal to the diameter of center profile 63 plus 2Dl tan (δ). The diameter of the right profile member 62 is equal to the diameter of the center profile member 63 plus 2Dr tan (δ).

Angle δ is chosen so that failure occurs between break wheel profiles 60 and 62 or a short distance ahead of break wheel motion. Typically, the angle of break plane surface 58 is adjusted to equal angle δ so that the left wheel profile member 60 and center profile member 63 engage the substrate 18 simultaneously. If the surface break plane 58 is adjusted to an angle less than δ then the downward travel of the break wheel is limited only by left profile member 60, so that the maximum induced tensile strain across the scribe line 24 is reduced. If the surface break plane 58 is adjusted to more than angle δ, then the downward travel of the break plane wheel is still limited by center profile member 63 so that the maximum induced tensile strain across scribe line 24 is still equal to the strain developed when surface break plane angle surface 58 is set to angle δ.

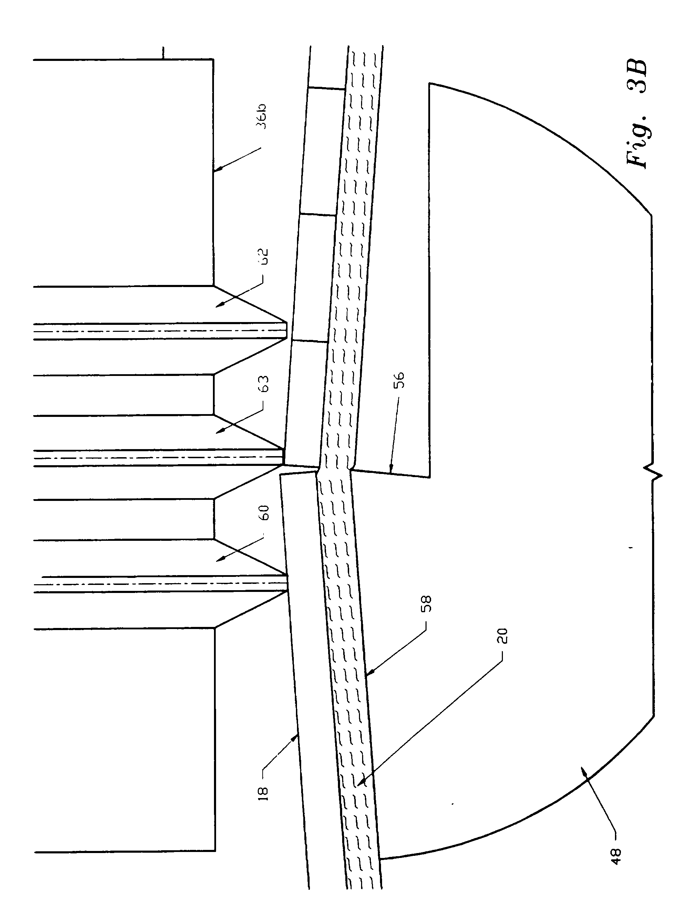

Figs. 3A and 3B show another form of break wheel 36b which is used if the back side or bottom side of wafer 18 has a coating of ductile metallization or the ductile material that does not break easily with the substrate, thereby making the substrate prone to "gold hinge". In such a case, the wheel 36b is used and such wheel uses a group of three profile members 60, 62 and 63 except at the center edge 56 of mandrel 48.

In using the embodiment of Fig. 3A, wafer 18 is again held on a stretchable sheet 20 as described above with the other embodiments. Sheet 20 is held taut by hoop frame 22 over mandrel 48.

Wafer 18 is aligned transversely along the x-axis (Fig. 5) and rotationally about the θ axis (Fig. 5) so that separation grid channel and the most recent scribe line 24 are parallel and superimposed over break edge 56 of mandrel 48. The break edge 56 is at the center of rotation of mandrel 48 to ensure break edge 56 is stationary during the adjustment of angle adjustment of the break plane surface 58 of the mandrel.

Scribed line 24 traverses entirely a separation grid channel which is located over break edge 56. The movement of the tool 16 is accomplished by linear translation system actuator 14 (Figs. 5 and 6) which convey scribe tool 16 and break wheel system 30 to the left and then to the right when viewing Fig. 6.

Tensile strain is created transversely across scribe line 24 by pushing wafer 18 on opposite sides of scribe line 24 with break wheel profile members 60 and 62. Members 60 and 62 roll across wafer 18 parallel to scribe line 24 as they are conveyed by the translation system 14, causing tensile strain across the scribe line to travel along the length of scribe line 24.

The maximum tensile strain induced across the scribe line 24 is adjusted by changing the angle of the break plane surface 58 of the mandrel 48. When surface 58 is rotated counterclockwise around break edge 56, profile members 60 and 62 bend the wafer more about scribe line 24 and thus induce more tensile strain across the scribe line 24 prior to scribe line 24 breaking. Conversely, the tensile strain is reduced when break plane surface 58 is rotated clockwise around break edge 56.

The maximum tensile strain across scribe line 24 is adjusted so that failure occurs along scribe line 24 directly between break wheel profile members 60 and 62 or a short distance in front of break wheel motion. As the break occurs along the scribe line 24, the newly broken strips or dice 25 are pushed down by center profile 63, thus creating a shearing action between the newly broken strip or die 25 and the unbroken substrate 18. This shearing action cuts and separates the backside metallization directly under scribe line 24.

As in the first embodiment, the left profile member 60 of the embodiment of Fig. 3a engages the unbroken substrate 18 over the inclinable mandrel surface 58, thus limiting the break wheel downward travel so that the angle of the mandrel break plane surface 58 sets the maximum strain induced around the unbroken scribe line. As the substrate 18 breaks along the scribe line, the center wheel profile member 63 pushes the newly broken strip or die down, causing a shearing action to take place between the unbroken substrate 18 and newly broken portions 25. This helps to shear any backside metallization. Other breaking techniques fail to address the issue of ductile, backside metallization, which generally leaves the wafer in a condition where the chips are broken from each other yet still attached by a way of the backside metal, generally referred to as "gold hinge".

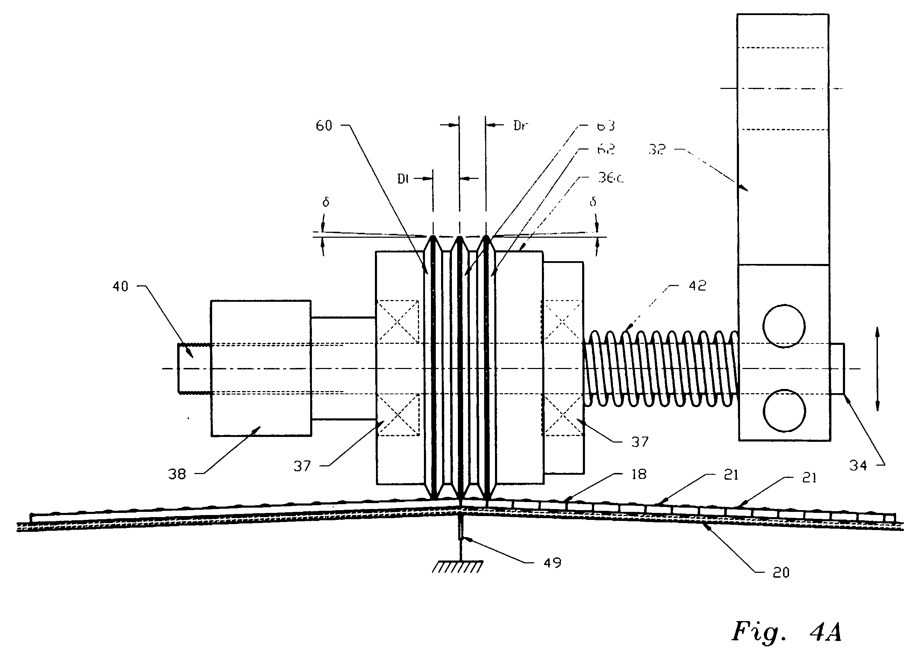

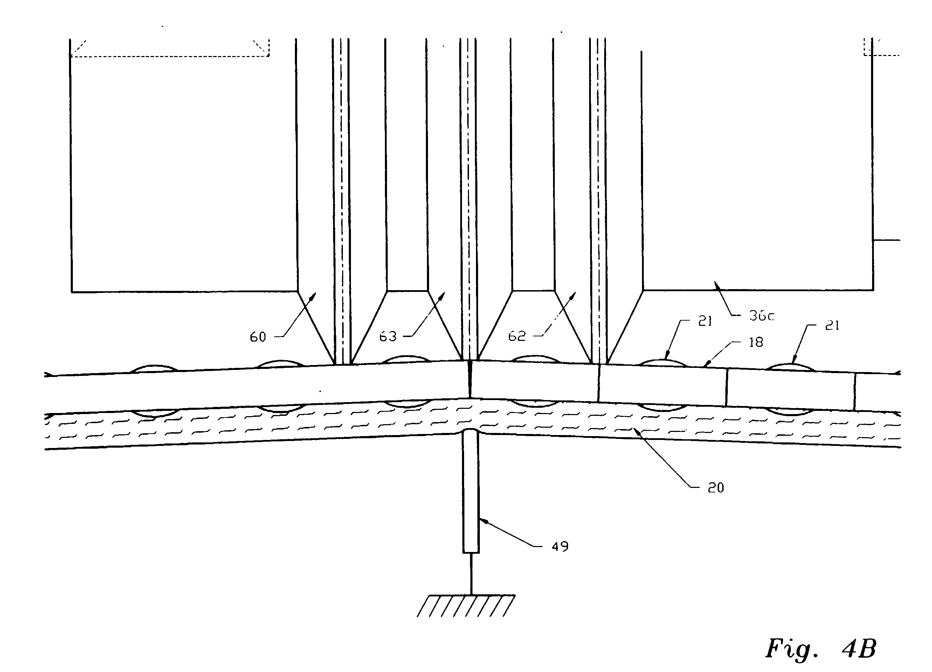

In the fourth embodiment of the present invention as shown in Figs. 4A and 4B, the separation grid of the substrate is not in the same plane as the rest of the substrate, as in wafers where large contact "bumps" are part of the active circuit area. In this embodiment, the breaking wheel 36c is the same as in the second embodiment with the center wheel profile member 63 engaging the substrate 18 directly over the scribe line 24. The mandrel 48 is replaced with a fixed narrow plate or blade 49 which fits between the bumps on the substrate. Since the center wheel profile is limited in this downward travel by the substrate supported on the blade 49, the breaking strain is controlled by the contact angle between the center and outer profile members of the break wheel.

The substrate 18 is sometimes formed with relatively large contact bumps 21 in active circuit areas so that the separation grid is not in the same plane as the rest of the substrate. Typically, the substrate is not able to seat properly on break plane surface 58 of mandrel 48 due to the unevenness of the contact plane 21. In this case, a three profile break wheel is used as in the second embodiment except that the mandrel 48 in the second embodiment is replaced by a fixed narrow blade 49 in the fourth embodiment with the blade being operable to fit between the contact areas as shown in Fig. 4B.

In use, the fourth embodiment includes a wafer 18 held on a stretchable adhesive sheet 20. The sheet is held taut by hoop frame 22 over fixed narrow blade 49 as shown in Fig. 4A. Wafer 18 is aligned transversely along the x-axis (Fig. 5) and rotationally about the θ axis (Fig. 5) so that separation grid channel and most recent scribe line 24 are parallel and superimposed over fixed narrow blade 49.

The scribe line 24 traverses entirely a separation grid channel which is located over fixed narrow blade 49. The traversing operation is accomplished by linear actuator 14 which conveys the scribe tool 16 and break wheel system 30 in one direction over the substrate.

Tensile strain is created transversely across the scribe line by pushing wafer 18 on opposite sides of scribe line 24 with break wheel profiles 60 and 62. These two members 60 and 62 roll across wafer 18 parallel to scribe line 24 as they are conveyed by the translation system 14, causing tensile strain across scribe line 24 to travel along the length of scribe line 24.

Tensile strain is limited by a center profile 63 engaging wafer surface 18 over fixed narrow blade 49, thus limiting downward travel of break wheel 36c. The maximum tensile strain developed as a function of the angle δ which in turn is a function of the diameter of the center profile 63 in relation to the outer profile members 60 and 62. Break wheel 36c is made so that the diameter of the left profile member 60 is equal to the diameter of the center profile 63 plus 2 D1 tan (δ). The diameter of the right profile member is equal to the diameter of center profile member 63 plus 2 Dr tan (δ). Angle δ is chosen so that the failure occurs between break wheel profile members 60 and 62 or a short distance ahead of break wheel motion.

In all embodiments of the break wheel, nut 38 can be quickly moved on and off end 40 of shaft 34. This permits quick replacement of a break wheel with another break wheel to accommodate a particular type of wafer.

## Claims

1. Apparatus (10) for processing a frangible substrate comprising:
means (20, 22) for mounting a substrate (18) to be processed;
a scribing tool (16);
means (26) for effecting an incremental relative movement between said substrate (18) and said scribing tool (16) along a first path;
means (14) mounting the scribing tool (16) for movement relative to and in scribing relationship to the substrate (18) along a second path (24) transverse to the first path;
means coupled with the tool for effecting a relative movement between the scribing tool and the substrate along said second path,
whereby the scribing tool (16) can successively scribe a number of lines in the substrate;
and
means (30) engageable with the substrate (18) and moveable longitudinally along said second path (24) relative to the substrate (18) for breaking the substrate (18) along lines (24) scribed by said scribing tool (16).

2. Apparatus (10) as set forth in Claim 1, wherein the mounting means (20, 22) is stationary, and the tool (16) and the breaking means (30) are movable past the mounting means.

3. Apparatus (10) as set forth in Claim 1, wherein the tool (16) and breaking means (30) are stationary and the mounting means (20, 22) is movable past the tool (16) and breaking means (30).

4. Apparatus (10) as set forth in Claim 1, wherein the breaking means (30) include means defining a three-point beam bending system.

5. Apparatus (10) as set forth in Claim 1, wherein said breaking means (30) includes a wheel (36) rotatable relative to the substrate (18) and engagable therewith to apply thereto a pair of beam bending forces.

6. Apparatus (10) as set forth in Claim 5, wherein said breaking means (30) includes a mandrel (48) below the wheel (36) for supporting the substrate (18) against downward movement as the wheel (36) applies said pair of bending forces.

7. Apparatus (10) as set forth in Claim 5, wherein said wheel (36) includes a pair of spaced, annular profile members (60, 62).

8. Apparatus (10) as set forth in Claim 7, wherein said pair of profile members (60, 62) are moveable in rolling relationship to one surface of the substrate (18), and a support means (48) is beneath and in supporting relationship to one part of the substrate (18).

9. Apparatus (10) as set forth in Claim 8, wherein said support means includes a mandrel (48) having a generally flat upper surface (58) for supporting said part of the substrate (18).

10. Apparatus (10) as set forth in Claim 9, wherein the support surface of said mandrel (48) is inclined and terminates at a break point on the mandrel (48), one of the profile members (60) being above the support surface and the other profile member (62) being above the scribed part of the substrate (18).

11. Apparatus (10) as set forth in Claim 10, wherein the tool (16) is above the mandrel (48) and in the vertical plane of said break point.

12. Apparatus (10) as set forth in Claim 7, wherein the profile members (60, 62) are in positions to engage the substrate on opposite sides of a scribe line (24).

13. Apparatus (10) as set forth in Claim 1, wherein said breaking means includes an arm 32 swingable in a vertical plane, a shaft (34) secured to and extending laterally from one end of the arm, a breaking wheel (36) rotatably mounted on said shaft, and quick release means (38, 40) removably holding the breaking wheel on the shaft.

14. Apparatus (10) as set forth in Claim 13, wherein is included a coil spring (42) surrounding the shaft (34) and extending between the end of the arm and the wheel.

15. Apparatus (10) as set forth in Claim 13, wherein said quick release means includes a threaded portion on the outer end (40) of the shaft and a nut (38) threadably mounted on the shaft outer end in a position to hold the break wheel on the shaft.

16. Apparatus (10) as set forth in Claim 13, wherein said break wheel (36) includes a wheel body of cylindrical configuration, and a pair of spaced, annular profile members (60, 62) secured to the outer surface of the break wheel body in surrounding relationship to the central axis of the shaft.

17. Apparatus (10) as set forth in Claim 16, wherein each profile member (60, 62) is transversely V-shaped.

18. Apparatus (10) as set forth in Claim 16, wherein each profile member (60, 62) has a flat outer face for engaging the substrate (18).

19. Apparatus (10) as set forth in Claim 16, wherein the profile members (60, 62) are in positions to engage the substrate on opposite sides of a scribe line (24) formed in the substrate (18) by the tool (16).

20. Apparatus (10) as set forth in Claim 13, wherein said breaking wheel (36) includes a cylindrical wheel body, and a group of three, annular, spaced profile members (60, 62, 63) mounted on the outer surface of the wheel body.

21. Apparatus (10) as set forth in Claim 20, wherein one of the profile members (63) is between the other two profile member (60, 62), said one profile member (63) being adapted to engage the substrate (18) near a scribe line (24) as the other two profile members (60, 62) engage the substrate (18) on opposite sides of the scribe line (24).

22. Apparatus as set forth in Claim 21, wherein the middle profile member (63) is vertically aligned with the scribe line (24) during the breaking phase in which the substrate (18) is broken along said scribe line (24).

23. Apparatus as set forth in claim 21,
wherein the middle profile member (63) is to one side of the scribe line as the other two profile members (60, 62) engage the substrate on opposite sides of the scribe line (24) to shear any backside metallization of the substrate (18) so as to avoid the "gold hinge" effect, i.e. the condition, where parts of the frangible substrate (18) is broken from each other but are still attached via backside metal.

24. Apparatus as set forth in Claim 1, wherein said breaking means includes a mandrel (48) below the substrate (18), said mandrel (48) having an inclinable surface (58) for engaging and supporting the unscribed part of the substrate (18), said mandrel (48) having a hemispherical outer surface defining a central axis, means (50) mounting the mandrel for rotation about the central axis of the mandrel (48), and means (52) coupled with the mandrel (48) for adjusting the inclination of said inclinable surface.

25. Apparatus (10) as set forth in Claim 24, wherein said adjustment means includes an adjustable screw (52).

26. Apparatus (10) as set forth in Claim 24, wherein said mandrel (48) has an arm projecting laterally therefrom, a screw for coupling the arm with a fixed support whereby rotation of the arm will cause rotation of the mandrel (48) on its support about its central axis.

27. Apparatus (10) as set forth in Claim 24, wherein the central axis of the mandrel (48) is located beneath and vertically aligned with a scribe line (29) to be broken by the breaking wheel (36).

28. Apparatus (10) as set forth in Claim 24, wherein said breaking means (30) include a wheel (36) having a pair of spaced, profile members (60, 62) mounted on the outer surface of the wheel body and a third profile member (63) mounted on the wheel body between the first and second profile members.

29. Apparatus (10) as set forth in Claim 28, wherein the third profile member (62) is vertically aligned with the central axis of the mandrel (48).

30. Apparatus (10) as set forth in Claim 28, wherein the third profile member is spaced laterally from the vertical plane passing through the central axis of the mandrel (48).

31. Apparatus (10) as set forth in Claim 1, wherein said breaking means (30) includes a break wheel (36) rotatably mounted above the substrate (18), the wheel (36) having a wheel body provided with a pair of first and second, annular profile members (60, 62) an a third profile member (63) between the first and second profile members, and a plate (49) having an upper edge, said plate being vertically aligned with the plane of the third profile member, said wheel being rotatable relative to the substrate for breaking the substrate on the scribe line in the vertical plane of said third profile member.

32. Method for processing a frangible substrate (18) comprising the steps of:
mounting a substrate (18) to be processed;
scribing a first line in one surface of said frangible substrate by means of a scribing tool (16); indexing said scribing tool for successively scribing a plurality of lines parallel to said first line in one surface of said frangible substrate;
moving a breaking means (30, 36) longitudinally along said lines relative to the substrate and breaking the substrate along the lines scribed by said scribing tool.

33. A method as set forth in Claim 32, wherein is included the step of rotating the substrate (18) through an angle of 90° after the substrate (18) has been broken into a number of strips so that the strips extend transversely to the direction of movement of the scribing force, and performing said repeating step until the strips have been broken.

34. A method as set forth in Claim 32, wherein is included the step of incrementally moving the substrate (18) relative to a predetermined reference after each line (24) is scribed thereon.

35. A method as set forth in Claim 32, including the step of holding the substrate (18) stationary as the scribe line is formed by the scribing tool (16).

36. A method as set forth in Claim 32, including the step of holding the scribe tool (16) stationary while moving the substrate (18) as a scribe line (24) is formed in the substrate.

37. A method as set forth in Claim 32, wherein the breaking step includes successively applying downward forces to the substrate (18) as a scribe line (24) is being formed therein.

38. A method as set forth in Claim 34 or 37, wherein said breaking includes rolling a surface over the substrate (18) relative thereto as the surface is biased downwardly.

39. A method as set forth in Claim 35, wherein is included the steps of holding the substrate (18) against movement as a breaking force is applied thereto.

40. A method as set forth in Claim 37, wherein the breaking step includes the step of applying a second downward force and a third upward force opposed to the second downward force.

41. A method as set forth in Claim 32, wherein the breaking step includes exerting three forces to the substrate (18) at spaced locations thereon to break the substrate along a scribe line (24).

42. A method as set forth in Claim 41, wherein two of the forces are exerted downwardly and the third force is exerted upwardly.

## Patentansprüche

1. Vorrichtung (10) zum Verarbeiten eines zerbrechlichen Substrats mit:
Mitteln (20, 22) zum Befestigen eines zu verarbeitenden Substrats (18);
einem Anritzwerkzeug (16);
Mitteln (26) zum Bewirken einer inkrementalen Relativbewegung zwischen dem Substrat (18) und dem Anritzwerkzeug (16) längs eines ersten Weges;
Mitteln (14), die das Anritzwerkzeug (16) zur Bewegung relativ zu und in ritzender Beziehung zu dem Substrat (18) längs eines zweiten Weges (24) quer zu dem ersten Weg befestigen;
Mitteln, die mit dem Werkzeug zur Bewirkung einer Relativbewegung zwischen dem Anritzwerkzeug und dem Substrat längs des zweiten Weges gekoppelt sind, wodurch das Anritzwerkzeug (16) sukzessive eine Anzahl von Linien in das Substrat ritzen kann;
und
Mitteln (30), die mit dem Substrat (18) in Eingriff gelangen können und longitudinal längs des zweiten Weges (24) relativ zu dem Substrat (18) bewegbar sind, um das Substrat (18) längs Linien (24) abzubrechen, die durch das Anritzwerkzeug (16) geritzt sind.

2. Vorrichtung (10) nach Anspruch 1, worin das Befestigungsmittel (20, 22) stationär ist und das Werkzeug (16) und das Abbrechmittel (30) an dem Befestigungsmittel vorbei bewegbar sind.

3. Vorrichtung (10) nach Anspruch 1, worin das Werkzeug (16) und das Abbrechmittel (30) stationär sind, und das Befestigungsmittel (20, 22) an dem Werkzeug (16) und dem Abbrechmittel (30) vorbei bewegbar ist.

4. Vorrichtung (10) nach Anspruch 1, worin das Abbrechmittel (30) Mittel umfaßt, die ein Dreipunkt-Balkenbiegesystem definieren.

5. Vorrichtung (10) nach Anspruch 1, worin das Abbrechmittel (30) ein Rad (36) umfaßt, das relativ zu dem Substrat (18) drehbar und damit in Eingriff bringbar ist, um daran ein Paar Balkenbiegekräfte aufzubringen.

6. Vorrichtung (10) nach Anspruch 5, worin das Abbrechmittel (30) einen Dorn (48) unter dem Rad (36) zum Stützen des Substrats (18) gegen eine Bewegung nach unten umfaßt, wenn das Rad (36) das Paar Biegekräfte aufbringt.

7. Vorrichtung (10) nach Anspruch 5, worin das Rad (36) ein Paar beabstandete, ringförmige Profilglieder (60, 62) umfaßt.

8. Vorrichtung (10) nach Anspruch 7, worin das Paar Profilglieder (60, 62) in rollender Beziehung zu einer Oberfläche des Substrats (18) bewegbar ist und ein Tragemittel (48) sich unterhalb und in tragender Beziehung zu einem Teil des Substrats (18) befindet.

9. Vorrichtung (10) nach Anspruch 8, worin das Tragemittel einen Dorn (48) mit einer im allgemeinen ebenen oberen Fläche (58) zum Tragen des Teils des Substrats (18) umfaßt.

10. Vorrichtung (10) nach Anspruch 9, worin die Trageoberfläche des Dorns (48) geneigt ist und an einem Abbrechpunkt auf dem Dorn (48) endet, wobei das eine der Profilglieder (60) sich über der Trageoberfläche und das andere Profilglied (62) sich über dem angeritzten Teil des Substrats (18) befindet.

11. Vorrichtung (10) nach Anspruch 10, worin das Werkzeug (16) sich über dem Dorn (48) und in der vertikalen Ebene des Abbrechpunktes befindet.

12. Vorrichtung (10) nach Anspruch 7, worin die Profilglieder (60, 62) sich in Positionen befinden, um mit dem Substrat auf entgegengesetzten Seiten einer Anritzlinie (24) in Eingriff zu gelangen.

13. Vorrichtung (10) nach Anspruch 1, worin das Abbrechmittel einen Arm (32), der in einer vertikalen Ebene schwenkbar ist, eine Welle (34), die befestigt ist an und sich lateral erstreckt von einem Ende des Arms, ein Abbrechrad (36), das drehbar auf der Welle befestigt ist, und Schnellösemittel (38, 40) umfaßt, die das Abbrechrad abnehmbar auf der Welle halten.

14. Vorrichtung (10) nach Anspruch 13, worin eine Schraubenfeder (42) enthalten ist, die die Welle (34) umgibt und sich zwischen dem Ende des Arms und dem Rad erstreckt.

15. Vorrichtung (10) nach Anspruch 13, worin das Schnellösemittel einen Gewindeteil auf dem äußeren Ende (40) der Welle und eine Mutter (38) umfaßt, die schraubbar auf dem äußeren Ende der Welle in einer Position befestigt ist, um das Abbrechrad auf der Welle zu halten.

16. Vorrichtung (10) nach Anspruch 13, worin das Abbrechrad (36) einen Radkörper mit zylindrischer Konfiguration und ein Paar beabstandete, ringförmige Profilglieder (60, 62) umfaßt, die an der äußeren Oberfläche des Abbrechradkörpers in umgebender Beziehung zu der zentralen Achse der Welle befestigt sind.

17. Vorrichtung (10) nach Anspruch 16, worin jedes Profilglied (60, 62) quer V-förmig ist.

18. Vorrichtung (10) nach Anspruch 16, worin jedes Profilglied (60, 62) eine ebene äußere Fläche aufweist, um mit dem Substrat (18) in Eingriff zu gelangen.

19. Vorrichtung (10) nach Anspruch 16, worin die Profilglieder (60, 62) sich in Positionen befinden, um mit dem Substrat auf entgegengesetzten Seiten einer Anritzlinie (24) in Eingriff zu gelangen, die in dem Substrat (18) durch das Werkzeug (16) gebildet ist.

20. Vorrichtung (10) nach Anspruch 13, worin das Abbrechrad (36) einen zylindrischen Radkörper und eine Gruppe von drei kreisförmigen beabstandeten Profilgliedern (60, 62, 63) umfaßt, die auf der äußeren Oberfläche des Radkörpers befestigt sind.

21. Vorrichtung (10) nach Anspruch 20, worin das eine der Profilglieder (63) sich zwischen den anderen zwei Profilgliedern (60, 62) befindet, wobei das eine Profilglied (63) ausgelegt ist, um mit dem Substrat (18) nahe einer Anritzlinie (24) in Eidgriff zu gelangen, wenn die anderen zwei Profilglieder (60, 62) mit dem Substrat (18) auf entgegengesetzten Seiten der Anritzlinie (24) in Eingriff gelangen.

22. Vorrichtung nach Anspruch 21, worin das mittlere Profilglied (63) vertikal mit der Anritzlinie (24) während der Abbrechphase ausgerichtet ist, in welcher das Substrat (18) längs der Anritzlinie (24) abgebrochen wird.

23. Vorrichtung nach Anspruch 21, worin das mittlere Profilglied (63) sich auf einer Seite der Anritzlinie befindet, wenn die anderen zwei Profilglieder (60, 62) mit dem Substrat auf entgegengesetzten Seiten der Anritzlinie (24) in Eingriff gelangen, um jegliche rückseitige Metallisierung des Substrats (18) abzuscheren und somit den "gold hinge"-Effekt zu vermeiden, d. h. den Zustand, in dem Teile des zerbrechlichen Substrats (18) voneinander abgebrochen, aber noch durch das rückseitige Metall verbunden sind.

24. Vorrichtung nach Anspruch 1, worin das Abbrechmittel eine Dorn (48) unter dem Substrat (18), wobei der Dorn (48) eine neigbare Oberfläche (58) zum Eingreifen und Tragen des nicht geritzten Teils des Substrats (18) aufweist, und der Dorn (48) eine hemisphärische äußere Oberfläche aufweist, die eine zentrale Achse definiert, Mittel (50), die den Dorn zur Rotation um die zentrale Achse des Dornes (48) befestigen, und Mittel (52) umfaßt, die mit dem Dorn (48) zur Einstellung der Neigung der neigbaren Oberfläche gekoppelt sind.

25. Vorrichtung (10) nach Anspruch 24, worin das Einstellungsmittel eine einstellbare Schraube (52) umfaßt.

26. Vorrichtung (10) nach Anspruch 24, worin der Dorn (48) einen Arm, der lateral davon vorsteht, und eine Schraube zum Koppeln des Arms mit einem festen Träger aufweist, wodurch eine Rotation des Arms eine Rotation des Dorns (48) auf seinem Träger um seine zentrale Achse hervorruft.

27. Vorrichtung (10) nach Anspruch 24, worin die zentrale Achse des Dorns (48) unterhalb und vertikal ausgerichtet mit einer Anritzlinie (24) angeordnet ist, die durch das Abbrechrad (36) abgebrochen werden soll.

28. Vorrichtung (10) nach Anspruch 24, worin die Abbrechmittel (30) ein Rad (36) mit einem Paar beabstandten Profilgliedern (60, 62), die auf der äußeren Oberfläche des Radkörpers befestigt sind, und einem dritten Profilglied (63) umfaßt, das auf dem Radkörper zwischen den ersten und zweiten Profilgliedern befestigt ist.

29. Vorrichtung (10) nach Anspruch 28, worin das dritte Profilglied (62) vertikal mit der zentralen Achse des Dorns (48) ausgerichtet ist.

30. Vorrichtung (10) nach Anspruch 28, worin das dritte Profilglied lateral von der vertikalen Ebene beabstandet ist, die durch die zentrale Achse des Dorns (48) tritt.

31. Vorrichtung (10) nach Anspruch 1, worin das Abbrechmittel (30) ein Abbrechrad (36), das drehbar über dem Substrat (18) befestigt ist, wobei das Rad (36) einen Radkörper aufweist, der mit einem Paar ersten und zweiten ringförmigen Profilgliedern (60, 62) und einem dritten Profilglied (63) zwischen den ersten und zweiten Profilgliedern versehen ist, und eine Platte (49) mit einer oberen Kante umfaßt, wobei die Platte vertikal mit der Ebene des dritten Profilgliedes ausgerichtet ist und das Rad relativ zu dem Substrat zum Abbrechen des Substrats auf der Anritzlinie in der vertikalen Ebene des dritten Profilgliedes drehbar ist.

32. Verfahren zum Verarbeiten eines zerbrechlichen Substrats (18), welches die Schritte umfaßt, daß:
ein zu verarbeitendes Substrat (18) befestigt wird;
eine erste Linie in eine Oberfläche des zerbrechlichen Substrats mittels eines Anritzwerkzeuges (16) geritzt wird;
das Anritzwerkzeug indexiert wird, um sukzessive eine Vielzahl von Linien parallel zu der ersten Linie in eine Oberfläche des zerbrechlichen Substrats zu ritzen;
ein Abbrechmittel (30, 36) longitudinal längs der Linien relativ zu dem Substrat bewegt wird und das Substrat längs der durch das Anritzwerkzeug geritzten Linien abgebrochen wird.

33. Ein Verfahren nach Anspruch 32, welches den Schritt umfaßt, daß das Substrat (18) um einen Winkel von 90° gedreht wird, nachdem das Substrat (18) in eine Anzahl von Streifen gebrochen ist, so daß die Streifen sich quer zur Bewegungsrichtung der Anritzkraft erstrecken, und daß der Wiederholungsschritt ausgeführt wird, bis die Streifen abgebrochen sind.

34. Ein Verfahren nach Anspruch 32, welches den Schritt umfaßt, daß das Substrat (18) relativ zu einer vorbestimmten Referenz inkremental bewegt wird, nachdem jede Linie (24) darauf geritzt worden ist.

35. Ein Verfahren nach Anspruch 32, welches den Schritt umfaßt, daß das Substrat (18) stationär gehalten wird, wenn die Anritzlinie durch das Anritzwerkzeug (16) gebildet wird.

36. Ein Verfahren nach Anspruch 32, welches den Schritt umfaßt, daß das Anritzwerkzeug (16) stationär gehalten wird, während das Substrat (18) bewegt wird, wenn eine Anritzlinie (24) in dem Substrat gebildet wird.

37. Ein Verfahren nach Anspruch 32, worin der Abbrechschritt umfaßt, daß sukzessiv Kräfte nach unten auf das Substrat (18) aufgebracht werden, wenn eine Anritzlinie (24) darin gebildet wird.

38. Ein Verfahren nach Anspruch 34 oder 37, worin das Abbrechen umfaßt, daß eine Oberfläche über das Substrat (18) relativ dazu gerollt wird, wenn die Oberfläche nach unten vorgespannt wird.

39. Ein Verfahren nach Anspruch 35, welches die Schritte umfaßt, daß das Substrat gegen Bewegung gehalten wird, wenn eine Abbrechkraft darauf aufgebracht wird.

40. Ein Verfahren nach Anspruch 37, worin der Abbrechschritt den Schritt umfaßt, daß eine zweite Kraft nach unten und eine dritte Kraft nach oben entgegengesetzt zu der zweiten Kraft nach unten aufgebracht werden.

41. Ein Verfahren nach Anspruch 32, worin der Abbrechschritt umfaßt, daß drei Kräfte auf das Substrat (18) an beabstandeten Stellen darauf ausgeübt werden, um das Substrat längs einer Anritzlinie (24) abzubrechen.

42. Ein Verfahren nach Anspruch 41, worin zwei der Kräfte nach unten und die dritte Kraft nach oben ausgeübt werden.

## Revendications

1. Dispositif (10) pour traiter un substrat cassant comprenant :
un moyen (20, 22) de montage d'un substrat (18) à traiter ;
un outil de traçage (16) ;
un moyen (26) pour effectuer un déplacement relatif incrémentiel entre ledit substrat (18) et ledit outil de traçage (16) suivant une première trajectoire ;
un moyen (14) de montage de l'outil de traçage (16) pour déplacement par rapport au substrat (18), et dans une disposition par rapport à celui-ci permettant le traçage, suivant une seconde trajectoire (24) transversale à la première trajectoire ;
un moyen accouplé à l'outil pour effectuer un déplacement relatif entre l'outil de traçage et le substrat suivant ladite seconde trajectoire, ce par quoi l'outil de traçage (16) peut tracer successivement un certain nombre de traits dans le substrat ; et
un moyen de rupture (30) pouvant coopérer avec le substrat (18) et mobile longitudinalement suivant ladite seconde trajectoire (24) par rapport au substrat (18) pour rompre le substrat (18) suivant les traits (24) tracés par ledit outil de traçage (16).

2. Dispositif (10) selon la revendication 1, dans lequel le moyen de montage (20, 22) est fixe, et l'outil (16) et le moyen de rupture (30) sont mobiles devant le moyen de montage.

3. Dispositif (10) selon la revendication 1, dans lequel l'outil (16) et le moyen de rupture (30) sont fixes et le moyen de montage (20, 22) est mobile devant l'outil (16) et le moyen de rupture (30).

4. Dispositif (10) selon la revendication 1, dans lequel le moyen de rupture (30) comprend un moyen définissant un système de flexion à trois points.

5. Dispositif (10) selon la revendication 1, dans lequel ledit moyen de rupture (30) comprend une roue (36) mobile en rotation par rapport au substrat (18) et pouvant coopérer avec celui-ci pour lui appliquer une paire de forces de flexion.

6. Dispositif (10) selon la revendication 5, dans lequel ledit moyen de rupture (30) comprend un mandrin (48) sous la roue (36) pour supporter le substrat (18) pour l'empêcher de se déplacer vers le bas lorsque la roue (36) applique ladite paire de forces de flexion.

7. Dispositif (10) selon la revendication 5, dans lequel ladite roue (36) comprend une paire d'éléments profilés annulaires espacés (60, 62).

8. Dispositif (10) selon la revendication 7, dans lequel ladite paire d'éléments profilés (60, 62) est mobile dans une disposition permettant le roulement par rapport à une face du substrat (18), et dans lequel un moyen d'appui (48) est placé au-dessous, et dans une disposition permettant l'appui, d'une partie du substrat (18).

9. Dispositif (10) selon la revendication 8, dans lequel ledit d'appui comprend un mandrin (48) ayant une face supérieure d'appui (58) globalement plate pour supporter ladite partie du substrat (18).

10. Dispositif (10) selon la revendication 9, dans lequel la face d'appui dudit mandrin (48) est inclinée et se termine au droit d'un point de rupture sur le mandrin (48), l'un des éléments profilés (60) étant au-dessus de la face d'appui et l'autre élément profilé (62) étant au-dessus de la partie tracée du substrat (18).

11. Dispositif (10) selon la revendication 10, dans lequel l'outil (16) est au-dessus du mandrin (48) et dans le plan vertical dudit point de rupture.

12. Dispositif (10) selon la revendication 7, dans lequel les éléments profilés (60, 62) sont dans des positions propres à contacter le substrat de chaque côté d'un trait de traçage (24).

13. Dispositif (10) selon la revendication 1, dans lequel ledit moyen de rupture comprend un bras (32) basculant dans un plan vertical, un arbre (34) fixé à une extrémité du bras et s'étendant latéralement par rapport à celle-ci, une roue de rupture (36) montée de façon mobile en rotation sur ledit arbre, et un moyen à déclenchement (38, 40) maintenant de façon amovible la roue de rupture sur l'arbre.

14. Dispositif (10) selon la revendication 13, dans lequel est inclus un ressort hélicoïdal (42) entourant l'arbre (34) et s'étendant entre l'extrémité du bras et la roue.

15. Dispositif (10) selon la revendication 13, dans lequel le moyen à déclenchement comprend une partie filetée sur l'extrémité extérieure (40) de l'arbre et un écrou (38) monté par vissage sur l'extrémité extérieure d'arbre dans une position propre à maintenir la roue de rupture sur l'arbre.

16. Dispositif (10) selon la revendication 13, dans lequel ladite roue de rupture (36) comprend un corps de roue de conformation cylindrique, et une paire d'éléments profilés annulaires, espacés, (60, 62) fixés à la surface extérieure du corps de roue de rupture dans une disposition permettant d'entourer l'axe central de l'arbre.

17. Dispositif (10) selon la revendication 16, dans lequel chaque élément profilé (60, 62) a, transversalement, une forme en V.

18. Dispositif (10) selon la revendication 16, dans lequel chaque élément profilé (60, 62) a une face extérieure plate pour contacter le substrat (18).

19. Dispositif (10) selon la revendication 16, dans lequel les éléments profilés (60, 62) sont dans des positions propres à contacter le substrat de chaque côté d'un trait de traçage (24) formé dans le substrat (18) par l'outil (16).

20. Dispositif (10) selon la revendication 13, dans lequel ladite roue de rupture (36) comprend un corps de roue cylindrique, et un groupe de trois éléments profilés annulaires, espacés, (60, 62, 63) montés sur la surface extérieure du corps de roue.

21. Dispositif (10) selon la revendication 20, dans lequel l'un des éléments profilés (63) se trouve entre les deux autres éléments profilés (60, 62), ledit un élément profilé (63) étant conçu pour contacter le substrat (18) près d'un trait de traçage (24) alors que les deux autres éléments profilés (60, 62) contactent le substrat (18) de chaque côté du trait de traçage (24).

22. Dispositif selon la revendication 21, dans lequel l'élément profilé central (63) est aligné verticalement avec le trait de traçage (24) pendant la phase de rupture au cours de laquelle le substrat (18) est rompu suivant ledit trait de traçage (24).

23. Dispositif selon la revendication 21, dans lequel l'élément profilé central (63) est d'un côté du trait de traçage alors que les deux autres éléments profilés (60, 62) contactent le substrat de chaque côté du trait de traçage (24) pour cisailler une certaine métallisation au dos du substrat (18) de façon à éviter l'effet "de charnière d'or", c'est-à-dire, l'état dans lequel des parties du substrat cassant (18) sont rompues l'une par rapport à l'autre mais sont toujours attachées par le métal au dos.

24. Dispositif selon la revendication 1, dans lequel ledit moyen de rupture comprend un mandrin (48) sur le substrat (18), ledit mandrin (48) ayant une face inclinable (58) pour contacter et supporter la partie non tracée du substrat (18), ledit mandrin (48) ayant une surface extérieure hémisphérique définissant un axe central, un moyen (50) de montage du mandrin pour rotation autour de l'axe central du mandrin (48), et un moyen (52) accouplé au mandrin (48) pour régler l'inclinaison de ladite face inclinable.

25. Dispositif (10) selon la revendication 24, dans lequel ledit moyen de réglage comprend une vis de réglage (52).

26. Dispositif (10) selon la revendication 24, dans lequel ledit mandrin (48) comporte un bras qui en fait saillie latéralement, une vis pour accoupler le bras à un support fixe, ce par quoi la rotation du bras provoquera la rotation du mandrin (48) sur son appui autour de son axe central.

27. Dispositif (10) selon la revendication 24, dans lequel l'axe central du mandrin (48) est situé au-dessous d'un trait de traçage (29) et est aligné verticalement avec celui-ci pour être rompu par la roue de rupture (36).

28. Dispositif (10) selon la revendication 24, dans lequel ledit moyen de rupture (30) comprend une roue (36) comportant une paire d'éléments profilés, espacés, (60, 62) montés sur la surface extérieure du corps de roue et un troisième élément profilé (63) monté sur le corps de roue entre les premier et deuxième éléments profilés.

29. Dispositif (10) selon la revendication 28, dans lequel le troisième élément profilé (62) est aligné verticalement avec l'axe central du mandrin (48).

30. Dispositif (10) selon la revendication 28, dans lequel le troisième élément profilé est espacé latéralement par rapport au plan vertical passant par l'axe central du mandrin (48).

31. Dispositif (10) selon la revendication 1, dans lequel ledit moyen de rupture (30) comprend une roue de rupture (36) montée de façon mobile en rotation au-dessus du substrat (18), la roue (36) comportant un corps de roue pourvu d'une paire de premier et deuxième éléments profilés annulaires (60, 62) et un troisième élément profilé (63) entre les premier et deuxième éléments profilés, et une tôle (49) ayant un bord supérieur, ladite tôle étant alignée verticalement avec le plan du troisième élément profilé, ladite roue étant mobile en rotation par rapport au substrat pour rompre le substrat suivant le trait de traçage dans le plan vertical dudit troisième élément profilé.

32. Procédé pour traiter un substrat cassant (18) comprenant les étapes :
de montage d'un substrat (18) à traiter ;
de traçage d'un premier trait sur une face dudit substrat cassant à l'aide d'un outil de traçage (16) ;
de déplacement par pas dudit outil de traçage pour tracer successivement plusieurs traits, parallèles audit premier trait, dans une face dudit substrat cassant ;
de déplacement d'un moyen de rupture (30, 36) longitudinalement suivant lesdits traits par rapport au substrat ; et
de rupture du substrat suivant les traits tracés par l'outil de traçage.

33. Procédé selon la revendication 32, dans lequel est incluse l'étape de rotation du substrat (18) d'un angle de 90° après que le substrat (18) a été rompu en un certain nombre de bandes de sorte que les bandes s'étendent transversalement à la direction de déplacement de la force de traçage, et d'exécution de ladite étape de répétition jusqu'à ce que les bandes aient été rompues.

34. Procédé selon la revendication 32, dans lequel est incluse l'étape de déplacement incrémentiel du substrat (18) par rapport à une référence prédéterminée après que chaque trait (24) y a été tracé.

35. Procédé selon la revendication 32, incluant l'étape de maintien du substrat (18) fixe pendant que l'outil de traçage (16) forme le trait de traçage.

36. Procédé selon la revendication 32, incluant l'étape de maintien de l'outil de traçage (16) fixe pendant le déplacement du substrat (18) alors qu'un trait de traçage (24) est formé dans le substrat.

37. Procédé selon la revendication 32, dans lequel l'étape de rupture comprend l'application de manière successive, au substrat (18), de forces dirigées vers le bas pendant que le trait de traçage (24) y est formé.

38. Procédé selon la revendication 34 ou 37, dans lequel ladite rupture comprend le roulement d'une surface sur le substrat (18) par rapport à celui-ci, tandis que la surface est poussée vers le bas.

39. Procédé selon la revendication 35, dans lequel est comprise l'étape de maintien du substrat (18) pour empêcher tout déplacement tandis qu'une force de rupture lui est appliquée.

40. Procédé selon la revendication 37, dans lequel l'étape de rupture comprend l'étape d'application d'une deuxième force dirigée vers le bas et d'une troisième force dirigée vers le haut, opposée à la deuxième force dirigée vers le bas.

41. Procédé selon la revendication 32, dans lequel l'étape de rupture comprend l'application de trois forces au substrat (18) au droit d'emplacements espacés sur celui-ci pour rompre le substrat suivant un trait de traçage (24).

42. Procédé selon la revendication 41, dans lequel deux des forces sont exercées vers le bas et la troisième force est exercée vers le haut.
